# EUROPEAN PATENT APPLICATION

(11) **EP 1 865 377 A2**
(43) Date of publication of application: **12.12.2007**
(21) Application number: 06255323.5
(22) Date of filing: 16.10.2006
(51) Int. Cl.: G03F 7/00, G02B 3/00

(54) **Method of manufacturing high sag micro-lens and high sag micro-lens manufactured thereby**

(30) Priority: 14.10.2005 KR 20050097143
(71) Applicant: Samsung Electro-Mechanics Co., Ltd., Suwon, Kyungki-do (KR)
(72) Inventor: Lim, Chang Hyun, Suwon Kyungki-do (KR); Choi, Seog Moon, Kwanak-ku Seoul (KR); Lee, Sung Jun, Sungbook-ku Seoul (KR); Jeung, Won Kyu, Seocho-ku Seoul (KR); Park, Ji Hyum, Sungdong-ku Seoul (KR)
(74) Representative: Powell, Timothy John

(57) **Abstract**

The invention relates to a method of manufacturing a high-sag micro lens and a high-sag lens manufactured thereby. According to the method, high viscosity photoresists are coated and baked for multiple times and undergo a reflow to obtain a micro lens structures having a high sag, thereby manufacturing high-sag micro lenses.

## Description

### CLAIM OF PRIORITY

This application claims the benefit of Korean Patent Application No. 2005-97143 filed on October 14, 2005, in the Korean Intellectual Property Office, the disclosure of which is incorporated herein by reference.

### BACKGROUND OF THE INVENTION

### Field of the Invention

The present invention relates to a high-sag micro lens, and more particularly, to a method of manufacturing a high sag lens, in which high-viscosity photoresists are coated and baked for multiple times, and undergo a reflow, obtaining micro lens structures having a high sag, thereby manufacturing micro lenses having a high sag, and to a high-sag lens manufactured thereby.

### Description of the Related Art

LEDs have attracted attention recently as the next-generation light sources with their merits such as short response time, semi-permanent lifetime, and that they can be driven with low voltage and current. The LEDs are also used in illumination devices (for example, projectors) together with lenses and lens arrays.

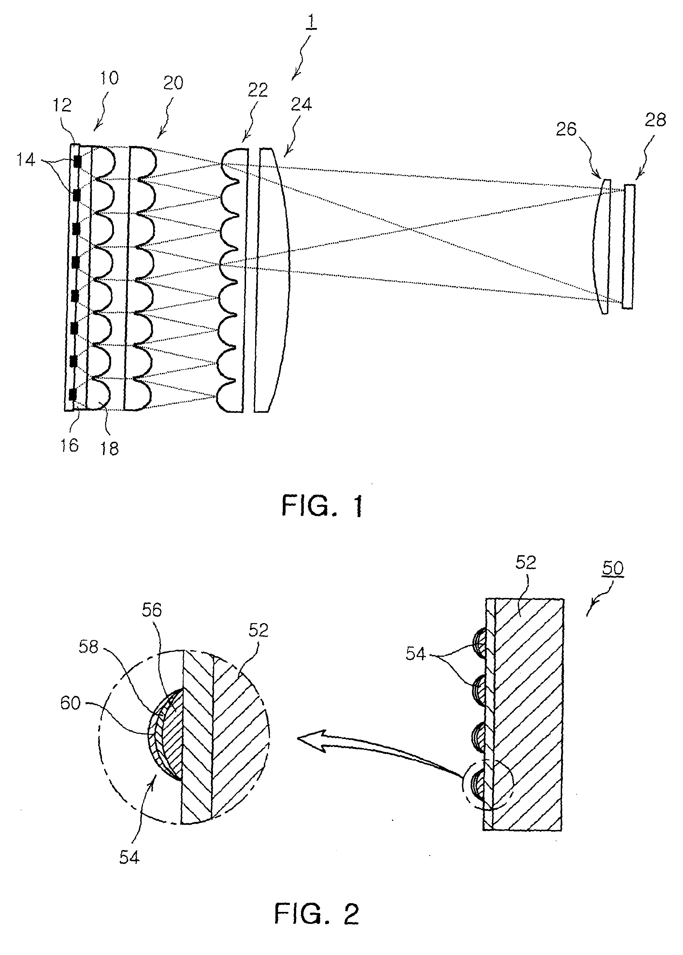

FIG. 1 illustrates an example of such an illumination device. As shown in FIG. 1, the illumination device 1 includes a light source 10 having a lens array 18, a pair of lens sheets 20 and 22 and a pair of convex lenses 24 and 26 disposed apart in a predetermined interval. The convex lens 26 guides incident light to a display panel 28.

Here, the light source 10 includes a substrate 12, a plurality of LED chips 14 mounted in a plurality of recessed portions (not shown) of the substrate 12, a transparent encapsulant 16 encapsulating the LED chips 14, and the lens array 18 attached onto the transparent encapsulant 16.

In this configuration, the light generated from the LED chips 14 passes through the lens sheets 20 and 22 and the convex lenses 24 and 26 and reaches the display panel 28.

Despite the various merits, the LEDs used in the illumination device as described above have shortcomings in terms of light efficiency, costs and luminance which make them inadequate for the substitution of the existing light sources.

In order to solve such a problem, refractive lenses manufactured by plastic injection molding have been used. However, the existing methods have limitations in preciseness, costs, mass-production, and expansion into multi-chip. Therefore, the integrated micro lens array structure and wafer-level process have been adopted to overcome the existing problems and improve optical capabilities including light efficiency of the LED package.

Various researches have been conducted to realize a micro lens array that can be processed at wafer-level using the Micro Electro Mechanical System (MEMS) technique. However, the resultant lens structures have heights (sags) of only tens of *µ*m. But a high-output LED for illumination requires a lens structure having a sag of hundreds of *µ*m.

In addition, the gray scale exposure technique, among the various existing manufacturing methods of the micro lens, does not yield a high sag of hundreds of *µ*m due to the limitation of the gray level. Further, the electron beam exposure and ion beam lighting methods have been attempted but turned out not suitable for yielding a micro lens array having a sag of hundreds of *µ*m. There are methods using dry etching and wet etching, also not suitable for yielding a high sag and good luminance intensity of the lens surface.

FIG. 2 illustrates a conventional manufacturing method of a high sag lens.

However, according to the method shown in FIG. 2, the replica method is repeated many times to mold a high sag lens 50. Repeating the replica method at least twice to manufacture a lens part 54 requires a considerable amount of time for the entire process, for example, repetition of replica process including polymer drop, compression, UV curing and releasing.

Moreover, the replica method requires additional molds (not shown) having different Numeric Aperture (NA) values applied to each of the lens layers 56, 58 and 60.

Alternatively, a lens mold can be manufactured by a Diamond Turning Machine (DTM), expanded into an array and manufactured into a high-sag lens array via the replica or molding.

However, when the mold is machined via laser beam, the manufacturable sag of the lens is in direct proportion to the thickness of a photoresist layer formed after spin coating, which hinders manufacturing a lens having a high sag of hundreds of *µ*m. Further, when the mold is machined via laser beam, it is difficult to form an aspherical surface and there are limitations in the types of aspherical surfaces that can be manufactured.

### SUMMARY OF THE INVENTION

The present invention has been made to solve the foregoing problems of the prior art and therefore an object of certain embodiments of the present invention is to provide a method in which high-viscosity photoresists are coated and baked for multiple times, and then undergo a reflow to produce micro lens structures having a high sag.

Another object of certain embodiments of the invention is to manufacture a micro lens having a high sag from the micro lens structure obtained from the above method, thereby improving the light efficiency of an LED package using the high-sag micro lenses manufactured thereby.

According to an aspect of the invention for realizing the object, there is provided a manufacturing method of a high sag lens comprising steps of:
(a) repeatedly coating and baking a high viscosity photoresist on a silicon wafer to form a photoresist deposition layer;
(b) converting the photoresist deposition layer into a predetermined shape via exposure and development;
(c) heat-treating the converted photoresist deposition layer to obtain microlens-shaped structures having a high sag;
(d) obtaining a mold using the microlens-shaped structures, the mold having recesses conforming to the shape of the microlens-shaped structures; and
(e) forming lenses having a high sag using the mold and an optical polymer.

According to the present invention, the step (a) comprises repeating the coating and baking three times, the baking repeated under different conditions. At this time, the step (a) may comprise: (i) coating a photoresist for 30 seconds to 2 minutes at 200 to 500rpm and baking for 20 to 40 minutes in an oven at 40 to 70°C; (ii) coating a photoresist on a structure obtained from the step (i) for 30 seconds to 2 minutes at 200 to 500rpm and baking the photoresist for 3 hours to 5 hours in the oven at 60 to 80°C; and (iii) coating a photoresist on a structure obtained from the step (ii) for 30 seconds to 2 minutes at 200 to 500rpm and baking the photoresist for 4 hours to 6 hours in the oven at 80 to 110°C.

According to the present invention, the step (b) may comprise exposing the deposition layer to ultraviolet rays for 3 to 7 hours at 5mW/mm².

According to the present invention, the step (b) may comprise separating the deposition layer into a plurality of box-like or disk-like structures via development.

According to the present invention, the step (c) may comprise conducting a reflow for 1 to 5 minutes at 100 to 150°C.

According to the present invention, the micro lens-shaped structure obtained in the step (c) has a sag of at least 300µm and the lenses obtained in the step (e) have a sag of at least 300µm.

According to the present invention, the optical polymer comprises ultraviolet curable polymer.

According to another aspect of the invention for realizing the object, there is provided a high sag lens manufactured by the above-described method.

### BRIEF DESCRIPTION OF THE DRAWINGS

The above and other objects, features and other advantages of the present invention will be more clearly understood from the following detailed description taken in conjunction with the accompanying drawings, in which:

FIG. 1 is a schematic view illustrating a conventional illumination device using LEDs and a lens array;

FIG. 2 is a sectional view illustrating a conventional method of manufacturing a high-sag lens;

FIG. 3 is a flow chart illustrating a process of manufacturing a high-sag lens according to the present invention;

FIG. 4 is a sectional view illustrating a method of manufacturing a high-sag lens according to the present invention;

FIG. 5 is a perspective view illustrating a high-sag lens array manufactured according to the present invention; and

FIG. 6 is a graph showing a sag of a high-sag lens manufactured according to the present invention.

### DETAILED DESCRIPTION OF THE PREFERRED EMBODIMENT

Preferred embodiments of the present invention will now be described in detail with reference to the accompanying drawings.

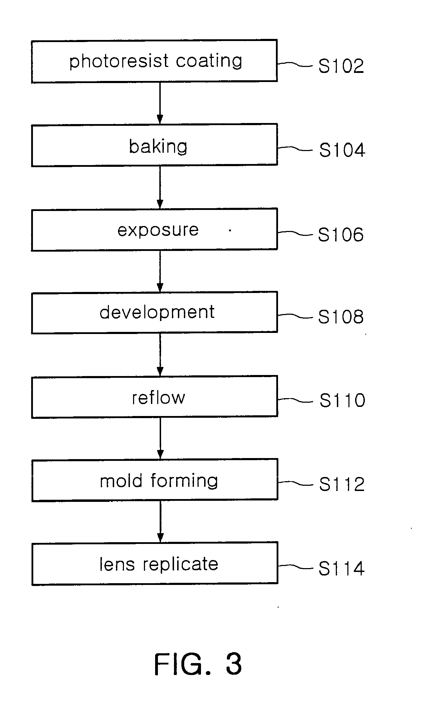

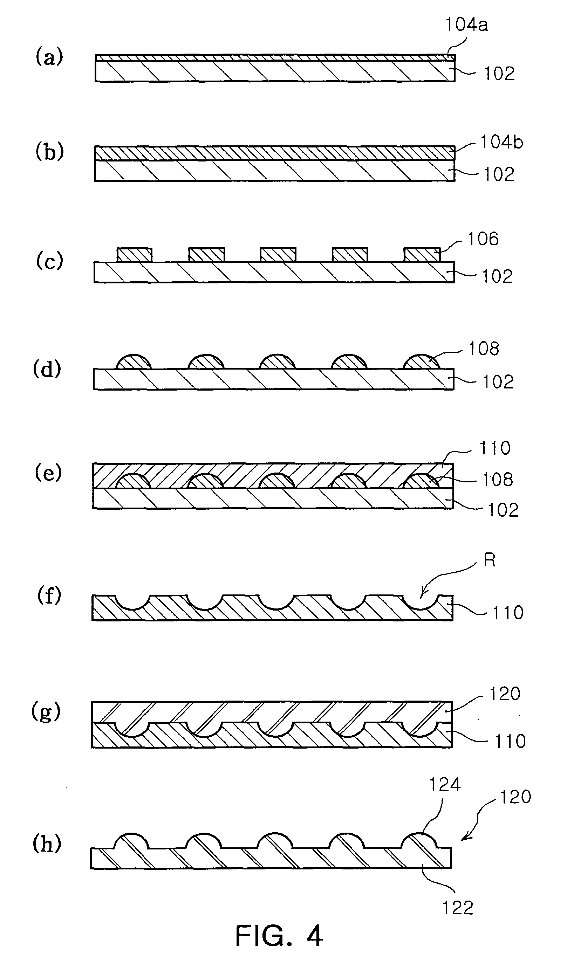

Referring to FIGS. 3 and 4, a manufacturing method of a high sag lens according to the present invention is explained hereunder.

First, a silicon wafer 102 is prepared, and then high-viscosity photoresist 104a is coated on the silicon wafer 102 at S102 and baked at S104 to form a photoresist deposition layer 104b in a preferable thickness of 140 to 250*µ*m. The coating and baking steps S102 and S104 are repeated for predetermined times, and preferably, for two or three times. The coating is conducted under the same conditions while the baking is conducted under different conditions.

More specifically, (a) photoresist is coated for 30 seconds to 2 minutes at 200 to 500rpm and baked in an oven for 20 to 40 minutes at 40 to 70°C , (b)photoresist is coated again for 30 seconds to 2 minutes at 200 to 500rpm on the above resultant structure from the step(a) and baked for 3 hours to 5 hours in the oven at 60 to 80°C, (c) photoresist is coated again on the resultant structure from the step (b) for 30 seconds to 2 minutes at 200 to 500rpm and baked for 4 hours to 6 hours in the oven at 80 to 110°C, thereby forming the previously described photoresist deposition layer 104b.

Then, the photoresist deposition layer 104b is converted into a predetermined shape of preliminary structures 106 via exposure at S106 and development at S108. For the exposure step S106, the photoresist deposition layer 104b is exposed to ultraviolet rays for 3 to 7 hours at 3 to 5mW/mm². In addition, for the development step S108, preferably the photoresist deposition layer 104b is developed for 6 to 7 hours at a room temperature using for example a developing solution, P-7G, commercially available from TOK. Thereby, the photoresist deposition layer 104b is converted into box-like or disk-like preliminary structures 106. The photoresist layer 104b is formed over a sufficiently large area of the silicon wafer 102 so that it can be converted into the plurality of preliminary structures 106 via exposure at S106 and development at S108.

Next, the preliminary structures 106 undergo heat treatment such as a reflow and thus are converted into micro lens-shaped structures 108 having a high sag at S110. Preferably, the heat treatment or the reflow is implemented for 1 to 5 minutes at 100 to 150°C. The micro lens structures 108 obtained in this process preferably have a high sag of at least 300*µ*m.

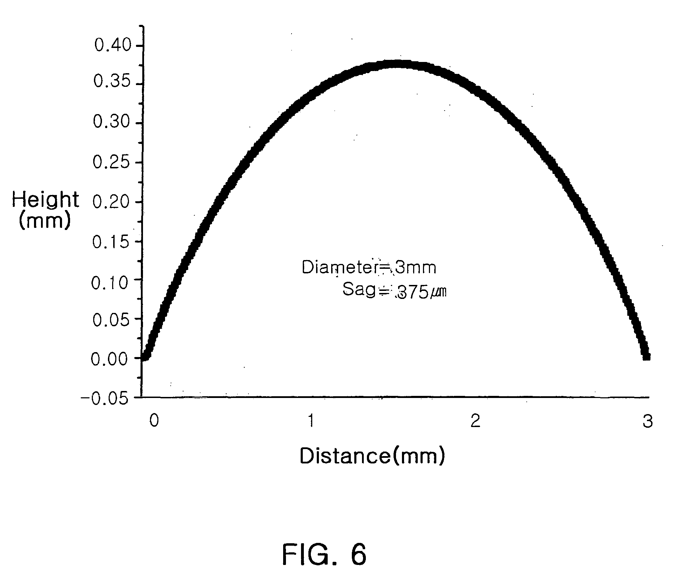

The high sag of the micro lens structure 108 can be seen in the graph of FIG. 6. Although the graph of FIG. 6 is for explaining a high-sag lens but can also be applied to explain the micro lens structure 108 for obtaining the lens.

Then, preferably, a seed layer (not shown) is formed on the lens structures 108 via deposition such as sputtering, electron beam, etc., and a sub-master or a mold 110 is formed via plating on the seed layer at S112. Here, a metal, preferably, Ni is plated on the seed layer to obtain the mold 110.

Then, the lens structures 108 are separated from the mold 110, and the mold 110 is placed upside down so that recessed parts R in the shapes of micro lenses are exposed as shown in FIG. 4(f).

The recessed parts R have the identical shape as the above described lens structures 108, and also have the identical shape with desired high-sag micro lenses to be completed later.

Then, an optical polymer is provided in the mold 110 and cured, thereby replicated into a desired lens sheet 120 at S114. The optical polymer is preferably a ultraviolet curable polymer, and is cured by irradiation of ultraviolet rays. This is because the ultraviolet curable polymer has superior resistance to heat. That is, the lens complete later is exposed to the heat generated from LED chips when used with the LED chips. Thus, when formed of ultraviolet curable polymer, the lens has superior resistance characteristics to the heat generated from the LED chips.

The preferable examples of the ultraviolet curable polymer include MIN-HR-1 available from Minuta Tech.

The lens sheet 120 obtained as above is separated from the mold 110, and it can be seen that a plurality of micro lenses 124 are protruded from a base part 122 of the sheet 120 as shown in FIG. 4 (f). The micro lenses 124 have the identical shapes as the lens structures 108 obtained from FIG. 4(d), and similarly have a high sag of at least 300*µ*m. The high sag of the lenses 124 is confirmed in the graph in FIG. 6.

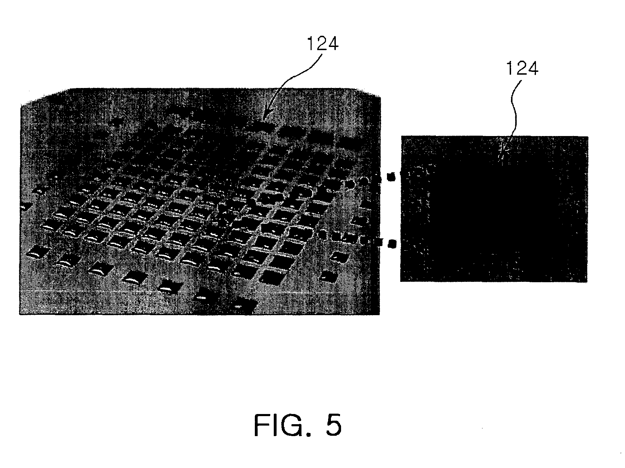

The high-sag lenses 124 obtained from the above described process may be used in the form of an array to guide the light generated from the LED chip as shown in FIG. 5. Alternatively, each of the high-sag lenses 124 can be used individually with an LED package.

### Example

According to the above described manufacturing method of a high sag lens, four types of high-sag lenses were manufactured. First, photoresists, HM-3000, available from TOK were coated on Si wafers for 1 minute at 500, 400, 350 and 250rpm, respectively, and baked for 30 minutes at 50°C in an oven. Then, the same coating procedure was repeated and the coated photoresists were baked for 3 hours and 30 minutes at 70°C in the oven. Then, the same coating procedure was repeated and the coated photoresists were baked for 5 hours at 90°C. Thereby, photoresist deposition layers as shown in FIG. 4(b) were obtained. The photoreist deposition layers were formed in thicknesses of 150, 170, 200 and 250*µ*m, respectively.

Then, the photoresist deposition layers were exposed for 5 hours using an ultraviolet exposure apparatus at an intensity level of 3.5mW/mm². Then, they were developed for 3 hours, 4 hours, 4 hours and 10 minutes, and 6 hours, respectively, at a room temperature using the developing solution, P-7G available from TOK, thereby obtaining the preliminary structures as shown in FIG. 4(c). Then, the preliminary structures underwent a reflow conducted for 2 minutes at 120°C on a hot plate to obtain lens structures shown in FIG. 4 (d). The obtained lens structures have sags of 300, 375, 400 and 500*µ*m, respectively.

Then, through the steps S112 and S114 in FIG. 3, i.e., in FIG. 4 (e) to (h), high-sag lenses having the identical shapes as the lens structures, i.e., having sags of 300, 375, 400 and 500*µ*m, respectively, were obtained.

In Table 1 below, light efficiency of the LED packages using the above high sag lenses are compared with that of the LED packages without the high-sag lenses. In Table 1, ηₑₓₜ refers to external light efficiency.

**Table 1**

| Lens sag (*µ*m) | ηₑₓₜ (%) |
|---|---|
| Without lens | 75.6 |
| 300 | 88 |
| 375 | 96 |
| 400 | 97 |
| 500 | 98 |

As examined above, using a high-sag lens of at least 300*µ*m allows high light efficiency. In particular, the high sag of at least 375*µ*m allow superior light efficiency of at least 96%. Considering the experimental errors, it can be seen that the light efficiency does not increase in direct proportion to the sag when the sag is 500*µ*m or more. The level of light efficiency at 375 to 400*µ*m of sag is not substantially different from the level of light efficiency at 500*µ*m of sag. Therefore, it is preferable that the micro lens has a sag of about 375 to 400*µ*m of sag.

According to the present invention set forth above, a high-viscosity photoresists are coated and baked for multiple times, and undergo a reflow, thereby obtaining micro lens structures having a high sag. Manufacturing high-sag micro lenses using the micro lens structures and applying the resultant high-sag lenses to an LED package improves light efficiency.

While the present invention has been shown and described in connection with the preferred embodiments, it will be apparent to those skilled in the art that modifications and variations can be made without departing from the spirit and scope of the invention as defined by the appended claims.

## Claims

1. A manufacturing method of a high sag lens comprising steps of:
(a) repeatedly coating and baking a high viscosity photoresist on a silicon wafer to form a photoresist deposition layer;
(b) converting the photoresist deposition layer into a predetermined shape via exposure and development;
(c) heat-treating the converted photoresist deposition layer to obtain microlens-shaped structures having a high sag;
(d) obtaining a mold using the microlens-shaped structures, the mold having recesses conforming to the shape of the microlens-shaped structures; and
(e) forming lenses having a high sag using the mold and an optical polymer.

2. The method according to claim 1, wherein the step (a) comprises repeating the coating and baking three times, the baking repeated under different conditions.

3. The method according to claim 2, wherein the step (a) comprises:
(i) coating a photoresist for 30 seconds to 2 minutes at 200 to 500rpm and baking for 20 to 40 minutes in an oven at 40 to 70°C;
(ii) coating a photoresist on a structure obtained from the step (i) for 30 seconds to 2 minutes at 200 to 500rpm and baking the photoresist for 3 hours to 5 hours in the oven at 60 to 80°C; and
(iii) coating a photoresist on a structure obtained from the step (ii) for 30 seconds to 2 minutes at 200 to 500rpm and baking the photoresist for 4 hours to 6 hours in the oven at 80 to 110°C .

4. The method according to claim 1, wherein the step (b) comprises exposing the deposition layer to ultraviolet rays for 3 to 7 hours at 5mW/mm².

5. The method according to claim 1, wherein the step (b) comprises separating the deposition layer into a plurality of box-like or disk-like structures via development.

6. The method according to claim 1, wherein the step (c) comprises conducting a reflow for 1 to 5 minutes at 100 to 150°C.

7. The method according to claim 1, wherein the micro lens-shaped structure obtained in the step (c) has a sag of at least 300µm.

8. The method according to claim 1, wherein the lenses obtained in the step (e) have a sag of at least 300µm.

9. The method according to claim 1, wherein the optical polymer comprises ultraviolet curable polymer.

10. A high sag lens manufactured by the method described in any preceding claim.
